(19) Europäisches Patentamt
European Patent Office
Office européen des brevets

(11) EP 1 777 808 A1

(12) EUROPEAN PATENT APPLICATION

(43) Date of publication:
25.04.2007 Bulletin 2007/17

(51) Int Cl.:
H03B 5/12 (2006.01)        H03B 5/36 (2006.01)

(21) Application number: 06021879.9

(22) Date of filing: 19.10.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 21.10.2005 JP 2005306588

(71) Applicant: Epson Toyocom Corporation
Hino-shi
Tokyo 191-8501 (JP)

(72) Inventor: Nomura, Norio
Kamiina-gun
Nagano-ken 399-4696 (JP)

(74) Representative: HOFFMANN EITLE
Patent- und Rechtsanwälte
Arabellastrasse 4
81925 München (DE)

(54) **High frequency Colpitts oscillation circuit**

(57)    A high frequency Colpitts oscillation circuit, comprises: a Colpitts oscillation circuit; and a collector grounded amplifier circuit, wherein an output terminal of the Colpitts oscillation circuit is coupled to an input terminal of the collector grounded amplifier circuit, and an output terminal of the collector grounded amplifier circuit is coupled to the Colpitts oscillation circuit as feedback.

FIG. 1

**Description**

BACKGROUND

1. Technical Field

The present invention relates to a piezoelectric oscillator, and in particular, to a piezoelectric oscillator that obtains large negative resistance in a high frequency range.

2. Related Art

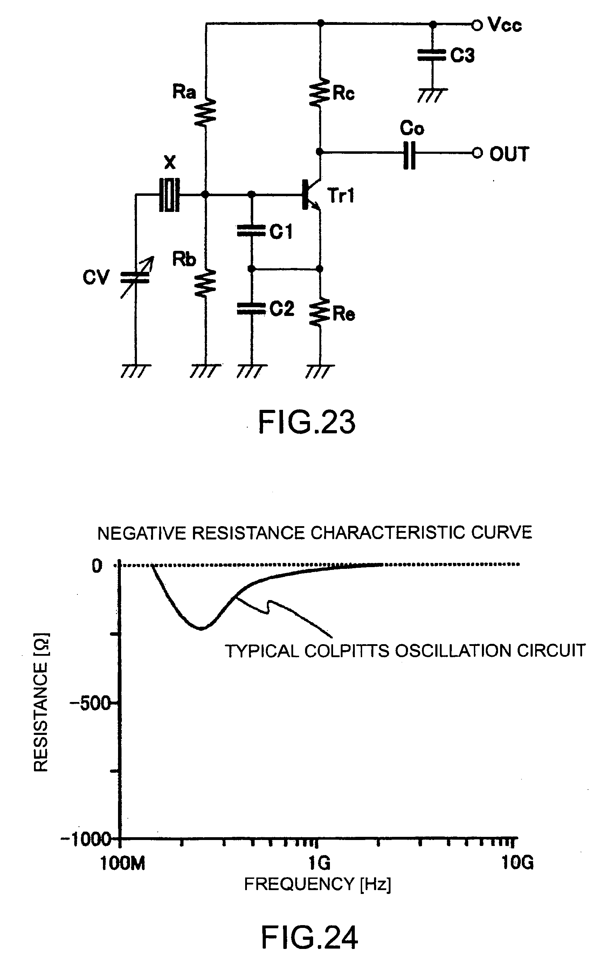

In recent years, accompanying the developments in wireless communication, there is a demand to make oscillators higher in frequency and more compact. Generally, crystal oscillators have excellent frequency stability, and currently are used over a wide range such as in communication equipment and computers. Usually, Colpitts oscillation circuits, which are structured so that an inductive element is connected between a collector and a base, and capacitive elements are respectively connected between the base and an emitter, and between the collector and the emitter, are often used as crystal oscillation circuits. Fig. 23 is a basic Colpitts oscillation circuit using a bipolar transistor. As the inductive element between the collector and the base of a transistor TR1, a series-connected element of a quartz crystal resonator X and a capacitor Cv (Cv is used for fine tuning oscillation frequency) is used between the base and the ground. Further, a series-connected element of capacitors C1 and C2 is connected between the base and the ground, a resistor Re is inserted between the emitter and the ground, and the emitter and the midpoint of the capacitors C1 and C2 are connected.

In the Colpitts oscillation circuit of Fig. 23, a power source Vcc is shortened to the ground (GND) in a high frequency manner by a bypass capacitor C3. Thus, an inductive element mainly composed of the quartz crystal resonator X is inserted between the collector and the base in an equivalent circuit manner. Further, since the midpoint of the capacitors C1 and C2 is connected to the emitter, the capacitor C1 is inserted between the base and the emitter of the transistor TR1, while the capacitor C2 is inserted between the collector and the emitter of the transistor TR1, resulting in the both capacitors to act as capacitive elements.

Here, the reason for using a quartz crystal resonator as an inductive element is that an oscillation circuit having stable frequency can easily be structured because the Q value is large, the ratio of changes in the equivalent inductance with respect to frequency changes is large, and the frequency control is easy.

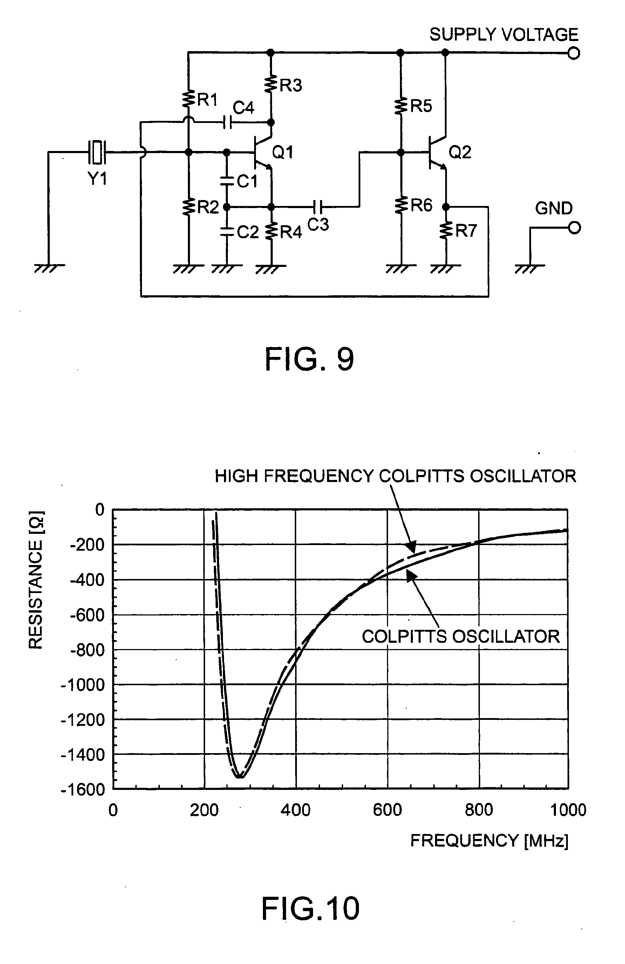

It is known that, in a Colpitts oscillation circuit, generally, the amplification degree viewing the circuit side from the both ends of the quartz crystal resonator X (the quartz crystal resonator and the capacitor Cv in the case of Fig. 23), i.e., so-called negative resistance R ($\Omega$) is inversely proportional to the capacitances of the capacitors C1 and C2, and $\omega^2$, which is the square of the frequency, and is proportional to a collector current. Namely, as shown by the simulated results of Fig. 10, as the frequency becomes higher, the absolute value of the negative resistance R ($\Omega$) increases, and reaches a peak value at a predetermined frequency, and thereafter, decreases as the frequency becomes higher. In a typical Colpitts crystal oscillator, the negative resistance R at oscillation frequency is generally set to about 3 to 5 times the equivalent resistance of the quartz crystal resonator, and is designed so that the negative resistance value is large at the desired oscillation frequency.

Here, examples of related art are as follows: Miyake, "Transistor Crystal Oscillator", the Journal of the Institute of Electronics, Information and Communication Engineers, Vol. 53, No. 6, pp. 771-777, 1970; Kawashima, Hirama, Saitou, Koyama, "Quartz Resonators and Devices", the Institute of Electronics, Information and Communication Engineers Transactions, C, Vol. J82-C, No. 12, pp. 667-682, Dec.1999; Sakuta, Mino, Sekine, "A Study on Phase Noise Measurement of High Accuracy Oscillator using Magnification of Phase Noise", the Institute of Electronics, Information and Communication Engineers Transactions, C, Vol. J82-C, No. 9, pp. 486-492, Sep.1999; and Shimono, "Crystal Oscillator Suppressing CI Dip Frequency Jump", the Institute of Electronics, Information and Communication Engineers Transactions, C, Vol. J85-C, No. 4, pp. 249-259, Apr.2002.

A problem to be solved is that, in a typical Colpitts crystal oscillation circuit such as shown in Fig. 24, it is difficult to obtain negative resistance value in the high frequency band, in particular, in the GHz band. Accordingly, it is difficult to cope with demands to operate oscillators at higher frequency as a clock frequency source. The demands are accompanied by the improvement in transmission speeds of information communication infrastructures that will become more important.

SUMMARY

In order to overcome the above problems, a high frequency Colpitts oscillation circuit of a first aspect of the invention includes a Colpitts oscillation circuit and a collector grounded amplifier circuit. The circuit is structured so that an output terminal of the Colpitts oscillation circuit is coupled to an input terminal of the collector grounded amplifier circuit, and an output terminal of the collector grounded amplifier circuit is coupled to the Colpitts oscillation circuit as feedback.

A high frequency Colpitts oscillation circuit of a second aspect of the invention includes a Colpitts oscillation circuit including a first transistor as an oscillation amplifier and a collector grounded amplifier circuit including a second transistor as an amplifier. The circuit is structured so that an emitter of the first transistor is coupled to a base of the second transistor, and a collector of the first transistor is coupled to an emitter of the second transistor.

In the second aspect of the invention, a parallel resonance circuit composed of a capacitor and an inductor is inserted and coupled between the emitter of the first transistor and the ground.

The Colpitts oscillation circuit of the invention (hereinafter called an expanded Colpitts oscillation circuit or a high frequency Colpitts oscillation circuit) is structured so that the output of a voltage source circuit is fed back to a collector side of a Colpitts oscillation circuit through a coupling capacitor in a voltage controlled piezoelectric oscillator, and has an advantage in that a large negative resistance is obtained even in a GHz band by a phase shift due to the coupling capacitor and the capacitor between a base and a collector.

A prototype VCSO having a frequency of 1GHz was made by using a high frequency Colpitts oscillation circuit and evaluated, showing favorable characteristics. In addition, a high frequency Colpitts oscillation circuit including a resonance circuit allows the peak of the negative resistance to be set around the oscillation frequency, resulting in the negative resistance being further increased. As a result, the circuit can be used in a higher frequency band as compared with a conventional high frequency Colpitts oscillation circuit, and can be oscillated at a low drive level.

BRIEF DESCRIPTION OF THE DRAWINGS

The invention will be described with reference to the accompanying drawings, wherein like numbers reference like elements.

Fig.1 is a circuit diagram illustrating an expanded Colpitts oscillation circuit according to the invention.

Fig.2 shows negative resistance characteristic curves of a conventional Colpitts oscillation circuit and the expanded Colpitts oscillation circuit according to the invention.

Fig.3 shows negative resistance characteristic curves of a conventional Colpitts oscillation circuit using an ideal transistor and the expanded Colpitts oscillation circuit according to the invention.

Fig. 4 shows a negative resistance characteristic curve of the conventional Colpitts oscillation circuit in a case where only the capacitance between a collector and an emitter is taken into consideration.

Fig. 5 shows a negative resistance characteristic curve of the conventional Colpitts oscillation circuit in a case where only the capacitance between a base and the collector is taken into consideration.

Fig.6 shows a circuit structure at the time of a small signal of the expanded Colpitts oscillation circuit according to the invention.

Fig.7 shows an example of a small signal equivalent circuit of the expanded Colpitts oscillation circuit according to the invention.

Fig.8 shows an embodiment of the expanded Colpitts oscillation circuit according to the invention.

Fig.9 shows a high frequency Colpitts oscillation circuit according to the invention.

Fig. 10 shows negative resistance curves when an ideal transistor is used.

Fig. 11 shows negative resistance curves in a case where an internal capacitance is taken into consideration.

Fig. 12 shows a circuit diagram of a VCSO.

Fig. 13 shows a simulation result on a negative resistance characteristic.

Fig. 14 shows a spurious characteristic.

Fig. 15 shows a frequency characteristic vs. supply voltage.

Fig. 16 shows a frequency temperature characteristic.

Fig. 17 shows frequency pullability.

Fig. 18 shows a phase noise characteristic.

Fig. 19 shows a high frequency Colpitts oscillation circuit including a resonance circuit.

Fig. 20 shows negative resistance characteristics.

Fig. 21 shows negative resistance characteristics.

Fig. 22 shows drive level characteristics.

Fig. 23 shows the conventional Colpitts oscillation circuit.

Fig. 24 shows the negative resistance characteristic curve of the conventional Colpitts oscillation circuit.

DESCRIPTION OF EXEMPLARY EMBODIMENTS

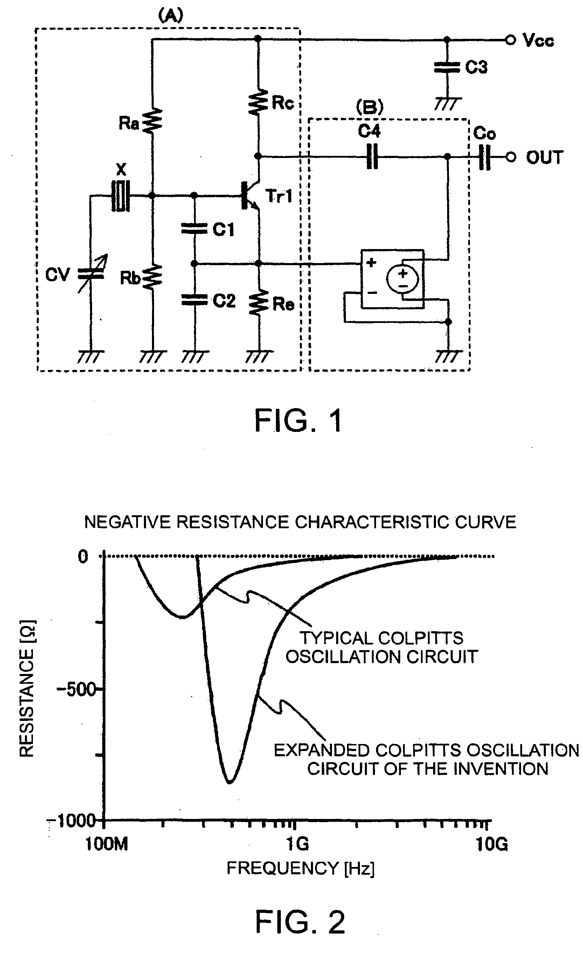

The Colpitts oscillation circuit of the invention (hereinafter called an expanded Colpitts oscillation circuit or a high frequency Colpitts oscillation circuit) will be described. Fig. 1 is a diagram showing the structure of an expanded Colpitts oscillation circuit according to the invention. The circuit is composed of a Colpitts crystal oscillation circuit using a bipolar transistor within the dashed line indicated by (A), and a voltage controlled voltage source circuit within the dashed line indicated by (B). The circuit indicated by (A) is the same as the circuit shown in Fig. 23, and the operation thereof has already been described. An operation of the voltage controlled voltage source circuit indicated by (B) will be explained. The circuit feeds back an alternating current without a DC component cut by a coupling capacitor C4 to the collector of Tr1 through the coupling capacitor C4.

An example of results of simulating the negative resistance characteristic of the expanded Colpitts oscillation circuit according to the invention is shown in Fig. 2. As is clear from Fig. 2, as compared with a typical Colpitts oscillation circuit, the expanded Colpitts oscillator of the invention can obtain a large negative resistance value in a higher frequency band than that of the conventional one. Namely, the peak of the negative resistance value of the typical Colpitts oscillation circuit is near 200 MHz, whereas the peak shifts about 400 to 500 MHz, and the absolute value thereof also becomes large. In particular, there is the feature that, even at several GHz, a negative resistance that is large enough for an oscillating operation can be obtained. Results of studying principle of this will be described hereinafter.

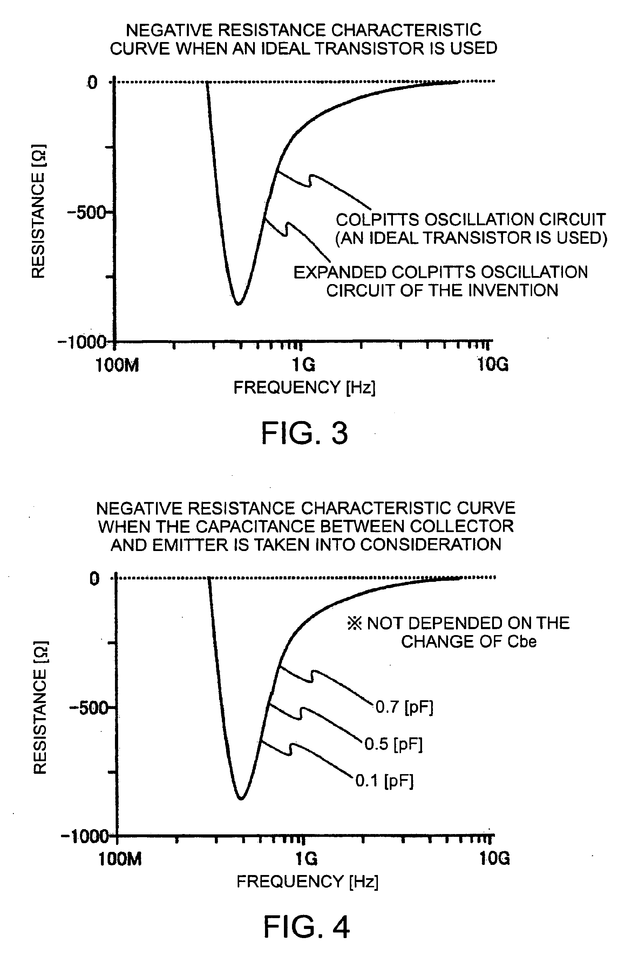

Fig. 3 shows the results of simulation of negative resistance characteristic curves of the expanded Colpitts oscillation circuit of the invention, and a conventional Colpitts oscillation circuit in a case in which the transistor Tr1 is assumed as an ideal transistor without consideration of the internal capacitance of the transistor Tr1. It is shown in Fig. 3 that, when an ideal transistor is used, the negative resistance characteristic curves of the conventional Colpitts oscillation circuit and the expanded Colpitts oscillation circuit of the invention are equivalent. The result shows that the reason why the Colpitts oscillation circuit does not obtain a large negative resistance value in the high frequency range is due to the internal capacitance of the transistor.

Thus, studies on the internal capacitance of the transistor are carried out. In Fig. 23 showing the conventional Colpitts oscillation circuit, the capacitance between the base and the emitter of the transistor Tr1 is obtained by combining the capacitance of the capacitor C1 in Fig. 9, and a fluctuation of the resulting capacitance between the base and the emitter of the transistor Tr1 is equivalent to that of the capacitor C1. Thus, here, studies and simulations are carried out on the capacitance between the collector and the emitter, and on the capacitance between the base and the collector.

Fig. 4 shows the results of simulation of the negative resistance characteristic curves when only the capacitance between the collector and the emitter of the transistor Tr1 in the circuit of Fig. 23 is considered and is varied to 0.7 pF, 0.5 pF, and 0.1 pF. This result shows that, even if the capacitance between the collector and the emitter varies, the obtained negative resistance value hardly changes at all.

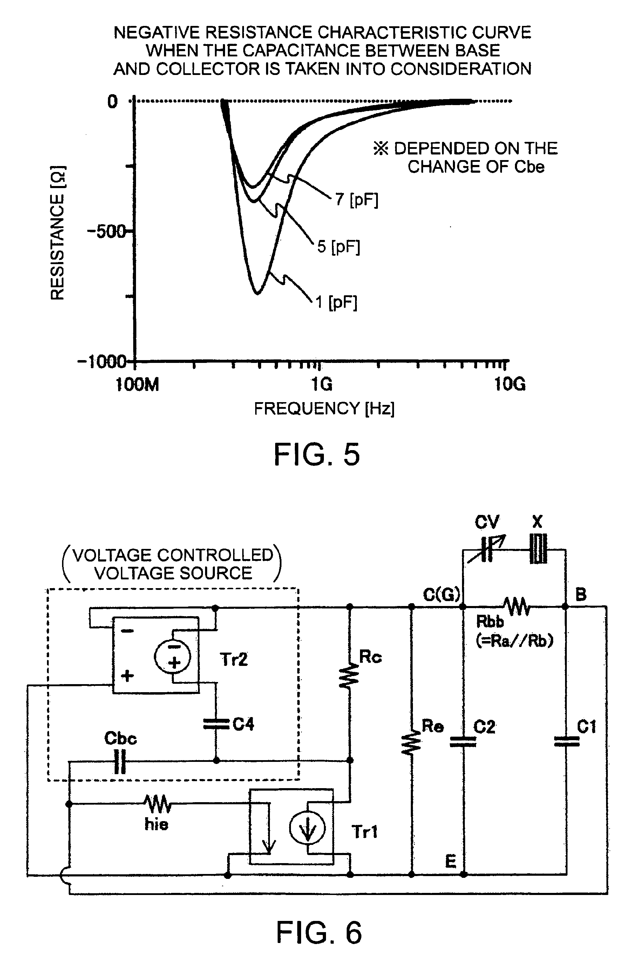

Fig. 5 shows the results of simulation of the negative resistance characteristic curves when only the capacitance between the base and the collector of the transistor Tr1 in the circuit of Fig. 23 is considered and is varied to 7 pF, 5 pF, and 1 pF. Fig. 5 shows that the obtained negative resistance value becomes larger by decreasing the capacitance between the base and the collector. Accordingly, it can be understood that the expanded Colpitts oscillation circuit of the invention is attributable to changes in the capacitance between the base and the collector.

Fig. 6 shows a simplified circuit structure of the voltage controlled voltage source circuit shown in Fig. 1(B) and the Colpitts oscillation circuit in Fig. 1(A) at a small signal. Here, Rbb in Fig. 6 denotes the equivalent resistor of the parallel connection of Ra and Rb in Fig. 1. Further, an input impedance hie of Tr1 is additionally denoted between the base and the emitter, and a capacitor Cbc between the base and the collector of Tr1 is additionally denoted between the base and the emitter.

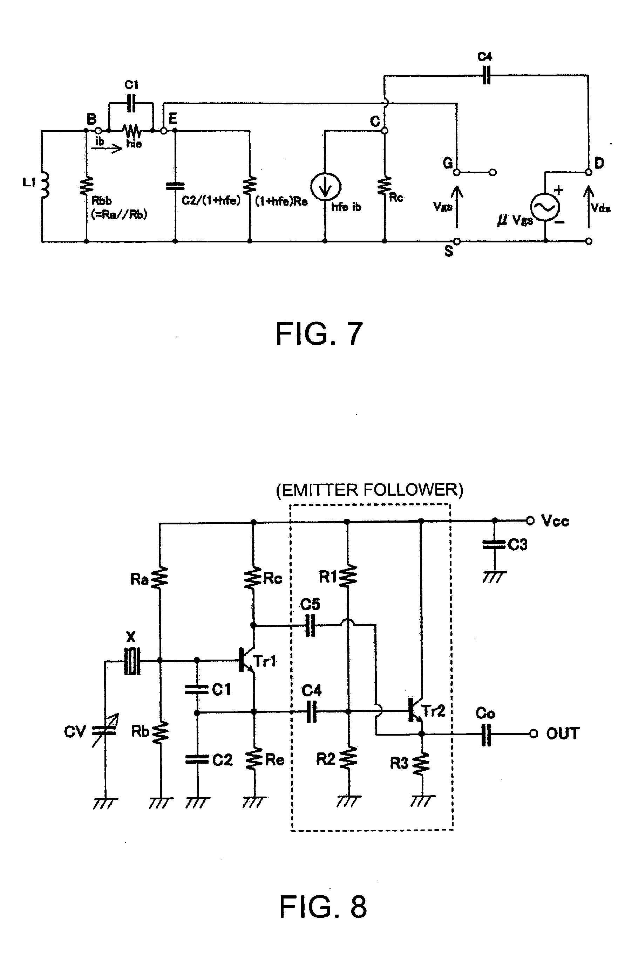

Further, Fig. 7 shows a small signal equivalent circuit in a case in which a source grounded FET amplification circuit is used for the voltage controlled voltage source of the circuit of Fig. 6.

Here, it is confirmed by a simulation that, even if parameters such as the values of the respective bias resistors or a current amplification rate hfe of the transistor Tr1 are varied, the frequency band of the obtained negative resistance value does not change.

Further, as is clear from Fig. 3, the negative resistance values of the expanded Colpitts oscillation circuit proposed herein and the conventional Colpitts oscillation circuit are equivalent if the internal capacitance of the transistor are not considered. Therefore, it is understood that the reason why a large negative resistance value is obtained in the GHz band by the expanded Colpitts oscillation circuit lies in the phase shift of the coupling capacitor C4 and the capacitor Cbc between the base and the collector in Fig. 6.

Fig. 8 shows one that utilizes the principle of the expanded Colpitts oscillation circuit proposed herein, and uses an emitter follower as the voltage controlled voltage source.

In this circuit structure, a bias is set by resistors R1, R2, and R3, and the emitter of the transistor Tr1, which is the output of the conventional Colpitts oscillation circuit, is connected, through the coupling capacitor C4, to the base that is the input of a transistor Tr2 included in the emitter follower. Further, the emitter of the transistor Tr2, which is the output of the transistor Tr2, is connected, through a coupling capacitor C5, to the collector of the transistor Tr1 as feedback.

In this circuit structure, it is confirmed that a large negative resistance value in the GHz band is obtained as compared with the conventional Colpitts oscillation circuit as similarly shown in Fig. 2, when simulation is carried out in accordance with the following parameters: C1=7 pF, C2=5 pF, C3=270 pF, C4=270 pF, Ra=3.3 kΩ, Rb=12 kΩ, Rc=82Ω, Re=220Ω, R1=2.2 kΩ, R2=15 kΩ, R3=1 kΩ, and Vcc=5 V.

Fig. 9 shows another embodiment of a high frequency Colpitts oscillation circuit according to the invention. The circuit is composed of a Colpitts oscillation circuit and a collector grounded amplifier circuit. In the circuit, the output of the Colpitts oscillation circuit is input to the collector grounded amplifier circuit, while the output of the collector grounded amplifier circuit is fed back to a collector side of the Colpitts oscillation circuit.

In other words, the high frequency Colpitts oscillation circuit shown in Fig. 9 includes the Colpitts oscillation circuit and the collector grounded amplifier circuit. The Colpitts oscillation circuit is structured as follows: one end of a resonator Yl is connected to the base of a transistor Q1; a parallel circuit is inserted and connected between the emitter of the transistor Q1 and the ground, and the parallel circuit is composed of the resistor R2 and a series circuit of the capacitors C1 and C2; a connecting midpoint of the series circuit is connected to the emitter of the transistor Q1; a resistor R4 is inserted and connected between the emitter of the transistor Q1 and the ground; the resistor R1 is inserted and connected between the base of the transistor Q1 and a supply voltage and the resistor R3 is inserted and connected between the collector of the transistor Q1 and the supply voltage.

In contrast, the collector grounded amplifier circuit is structured as follows: a base bias circuit composed of resistors R5 and R6 is inserted and connected to the base of a transistor Q2; a resistor R7 is inserted and connected between the emitter of the transistor Q2 and the ground; and the collector of the transistor Q2 is connected to the supply voltage.

Further, the high frequency Colpitts oscillation circuit is structured as follows: the collector of the transistor Q1 is connected to the emitter of the transistor Q2 through the capacitor C4; and the emitter of the transistor Q1 is connected to the base of the transistor Q2 through the capacitor C3.

Fig. 10 shows a negative resistance of an oscillator that has a frequency of 622.08 MHz and the transistor Q1 in an ideal condition by comparing with a typical Colpitts oscillation circuit. As is clear from Fig. 10, there is no difference in negative resistance characteristics when the transistor Q1 is in the ideal condition.

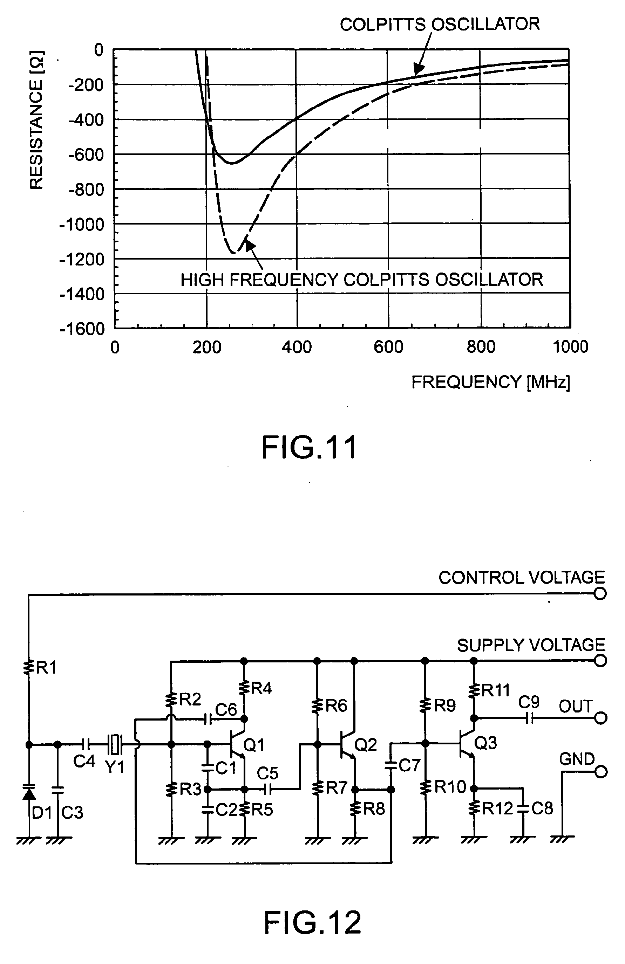

Fig. 11 shows negative resistance characteristics when the internal capacitance of the transistor Q1 is taken into consideration. From Fig.11, it is understood that the circuit is favorable to high frequency since the deterioration of the negative resistance due to the internal capacitance of the transistor Q1 is reduced by means in which the emitter output of the typical Colpitts oscillation circuit is input to the collector grounded amplifier circuit so as to be fed back to the collector of the oscillation circuit.

Table 1 shows the equivalent constants of a prototype surface acoustic wave (SAW) resonator having a frequency of 1 GHz. The resonator is favorable to obtain wide frequency pullability since the C1 value is large as shown in Table 1. In addition, Q is designed high due to small R1. As a result, an oscillator having exceptional phase noise characteristics can be achieved.

Table 1

| Symbol | No.1 | No.2 | No.3 |
|---|---|---|---|
| $f_s$ [MHz] | 1000.897 | 1000.940 | 1000.866 |
| $R_1$ [Ω] | 18. 2 | 18. 1 | 17. 9 |
| $L_1$ [μH] | 27. 758 | 27.148 | 27.217 |
| $C_1$ [fF] | 0.911 | 0.931 | 0.929 |
| $C_0$ [pF] | 1.672 | 1.694 | 1.708 |

Fig. 12 shows a circuit of a prototype voltage controlled SAW oscillator (VCSO) having a frequency of 1 GHz. An emitter grounded amplifier circuit is connected to the output of a high frequency Colpitts oscillation circuit so as to reduce the influence of load fluctuation as well as to ensure an output level. The output of the high frequency Colpitts oscillation circuit can be obtained from two parts i.e. a base side and a collector side of Q1. The base side is superior in phase noise characteristics, but is easily affected by external influences since it is in an oscillation loop. Thus, the output is obtained from the collector side by taking mass productivity into consideration.

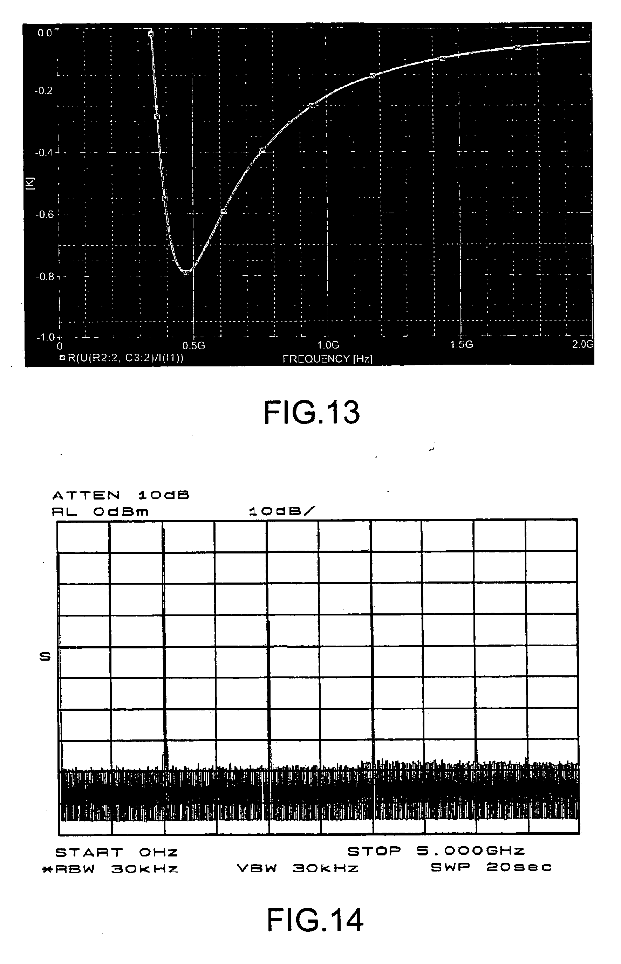

Fig. 13 shows a simulation result on the negative resistance characteristic of the VCSO. The negative resistance of minus 220 ohm (Ω) is obtained at 1 GHz. Judging from the loss of the SAW resonator, which is 20 Ω and below, the negative resistance is enough since the margin is 10 times.

Fig. 14 shows the spurious characteristic of the VCSO. It is understood that only harmonics exist without sub harmonics due to a fundamental oscillation. The sub harmonics are major factors deteriorating jitter characteristics of oscillators. No sub harmonics can reduce problems such as bit error in an apparatus.

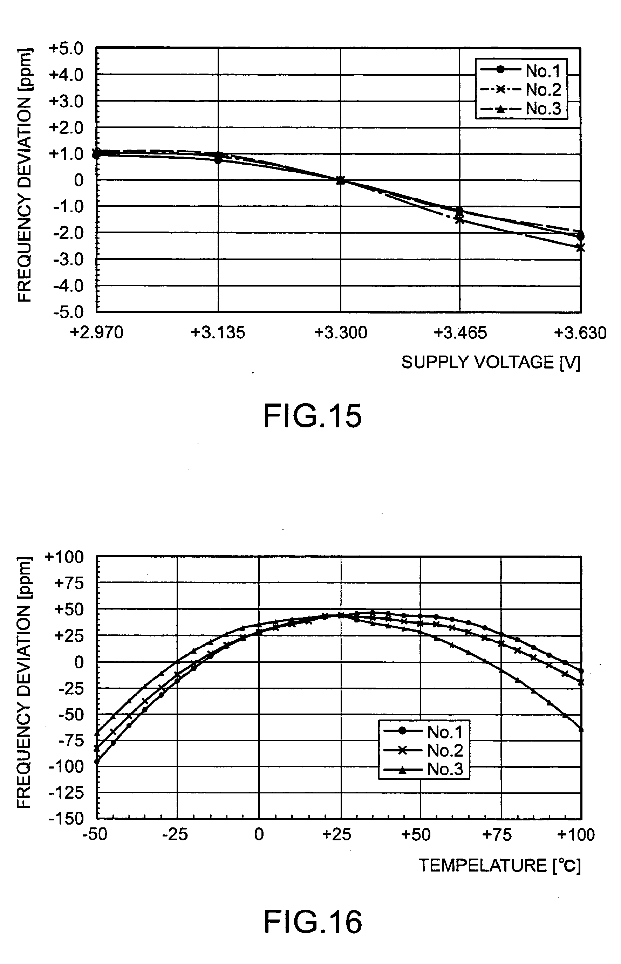

Fig. 15 shows a frequency characteristic with respect to a supply voltage. As is clear from Fig.15, the frequency is fluctuated within ± 2.0 ppm with respect to the supply voltage of + 3.3 V ± 5%. The characteristic is no way inferior to typical VCXO using a quartz crystal resonator, or the like. Also, the frequency fluctuation is adversely proportional to the increase of the supply voltage. This means that the influence of the capacitor Cbe between the base and emitter of the transistor Q1 dominates. The more increase of the supply voltage, the larger the capacitance value of the capacitor Cbe. As a result, the oscillation frequency becomes lower. This is because that Cbe connected in parallel with C1 dominates as compared with small C1 value due to high frequency. As a result, the frequency is adversely proportional to the increase of the supply voltage. Here, the consumption current is 11.5 mA, while the output level is minus 1.3 dBm/ 50Ω at the supply voltage of + 3.3 V.

Fig. 16 shows frequency temperature characteristics. Fig. 16 shows the frequency temperature characteristics in a case where the frequency at 25 degrees centigrade is shifted to a plus side by 50 ppm with respect to 1 GHz. As is clear from Fig. 16, the frequency temperature characteristic has stability within ± 60 ppm in the range from minus 40 degrees centigrade to plus 85 degrees centigrade.

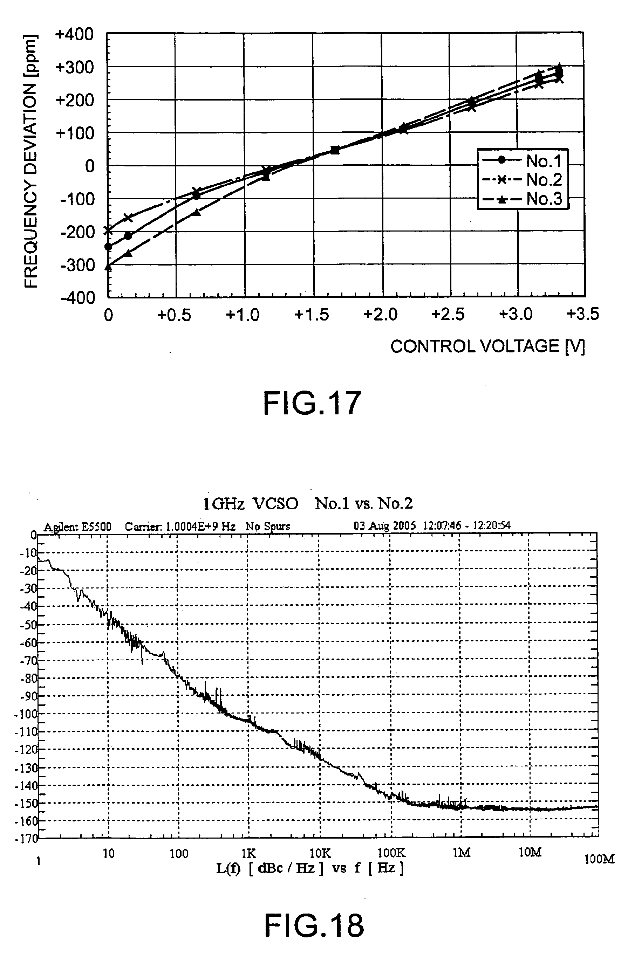

Fig. 17 shows frequency pullability. Fig. 17 shows the frequency pullability in a case where the frequency at + 1.65 V, which is the center value of frequency control voltage, is shifted to a plus side by 60 ppm with respect to 1 GHz in the same manner of the frequency temperature characteristics. As is clear from Fig. 17, wide pullability of ± 200 ppm and above can be achieved. An absolute frequency pullability ± 100 ppm, which is obtained by subtracting total stability from the frequency pullability, is a specification required to the VCSO. If the prototype VCSO has the total stability within ± 100 ppm, the specification can be satisfied when the frequency pullability is ± 200 ppm and above. However, variations are large when frequency control voltage is small. Thus, the reduction of the variations as well as the expansion of pullability will be further examined.

Fig. 18 shows phase noise characteristics. It is understood that the phase noise characteristic around carrier is extremely superior to a conventional delay line type VCSO. Conventionally, the VCSO has favorable jitter characteristics since spurious components caused by a source oscillation, which exist in PLL, does not exist. However, the VCSO has a problem in that phase noise around a carrier is not favorable. In contrast, the proposed high frequency Colpitts oscillation circuit has favorable phase noise characteristic around a carrier. Thus, characteristics can be obtained that is enough for being used even for optical transmission devices in which the VCSO cannot be used conventionally since the phase noise is not favorable.

A negative resistance $R_N$ of the circuit shown in Fig. 9 can be obtained by formula (1). This formula shows that the higher frequency, the more difficult to ensure the negative resistance. Here, $I_E$ is the emitter current of Q1, and Cbe is the capacitance between the base and emitter of Q1.

$$\text{Formula (1)}$$

$$R_N = -\frac{gm\, I_E}{(2\pi f)^2 (C_1 + C_{be}) C_2} \qquad (1)$$

A method ensuring the negative resistance by reducing the capacitance values of C1 and C2, or increasing $I_E$ has a limit. As is clear from Figs. 10 and 11, the peak of the negative resistance value exists around 300 MHz, which is about half of the oscillation frequency of 622.08 MHz. Therefore, in order to increase the negative resistance of the Colpitts oscillation circuit, the peak of the negative resistance needs to be shifted around the oscillation frequency.

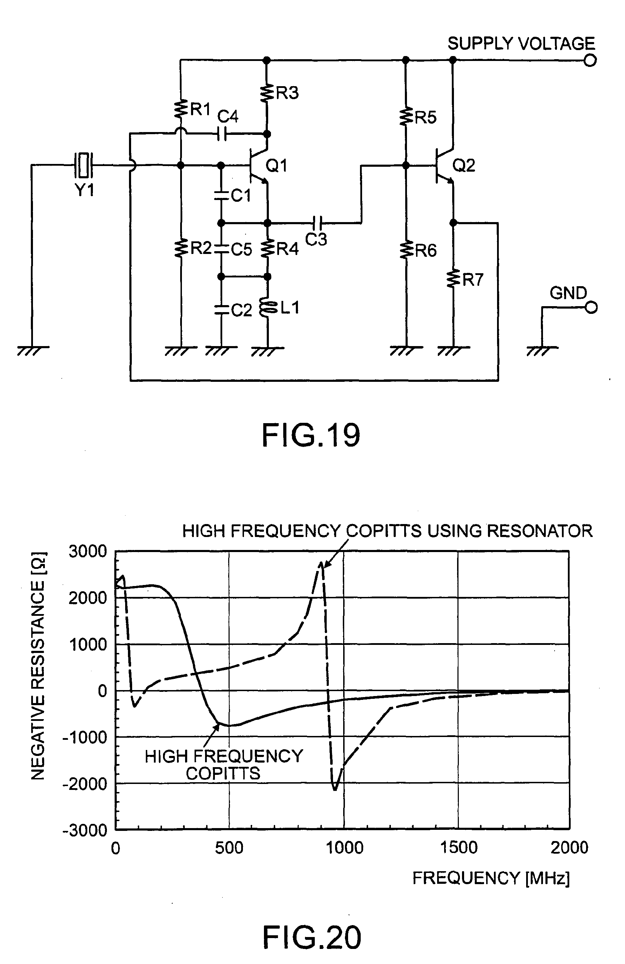

Consequently, a high frequency Colpitts oscillation circuit including a resonance circuit is proposed that can provide the peak of the negative resistance around the oscillation frequency. The resonance circuit (parallel resonance circuit composed of the capacitor C2 and an inductor L1) is provided in the oscillation circuit as shown in Fig. 19.

Fig. 20 shows the negative resistance characteristic compared with the high frequency Colpitts oscillation circuit. From Fig. 20, it is predictable that the negative resistance can be drastically increased by including a resonance circuit that provides the peak of the negative resistance around the oscillation frequency, and a usable range can be further extended to a higher frequency band.

Fig. 20 shows that the negative resistance characteristic of the high frequency Colpitts oscillation circuit can be made large by including the resonance circuit. However, a too large negative resistance causes abnormal oscillations, and lowers frequency stability. Thus, the negative resistance needs to be set adequately.

In a case where the SAW resonator shown in table 1 is used in the circuit shown in Fig. 19, the loss Re in the oscillation loop is obtained by formula (2), which is approximately 82 Ω.

$$Re = R_1(1+C_0/C_L)^2 \qquad\qquad (2)$$

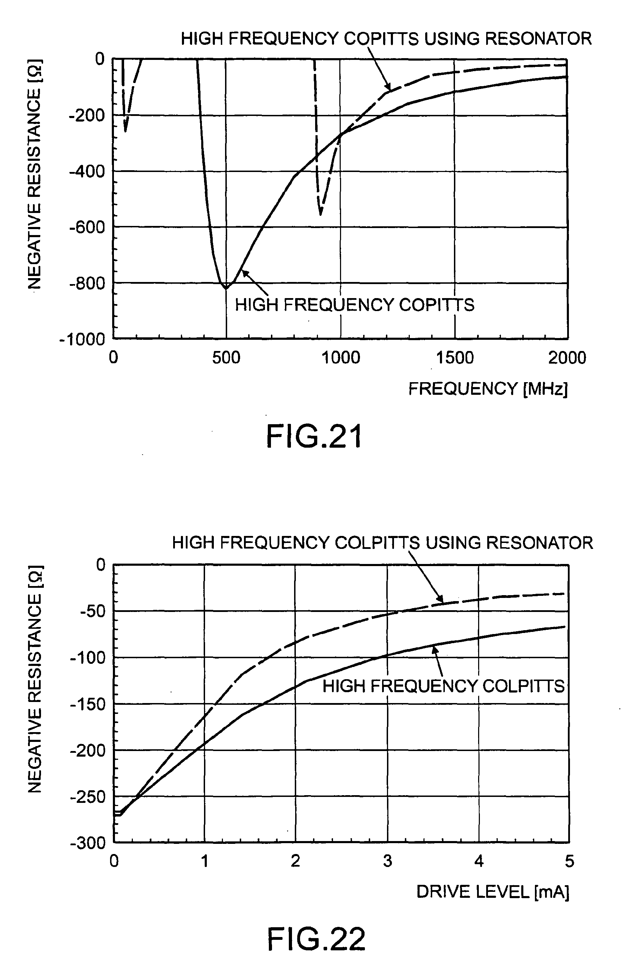

Therefore, the emitter current is designed small so that the negative resistance is to be minus 250 $\Omega$, which is about three times of the loss in the oscillation loop. Fig. 21 shows negative resistance characteristics. As is clear from the Fig. 21, the peak of the negative resistance of the high frequency Colpitts oscillation circuit including a resonance circuit exists around 1 GHz, while the peak of the negative resistance of the high frequency Colpitts oscillation circuit exists around 500 MHz. In addition, a negative part is small in a region where frequency is the oscillation frequency and below. As a result, the circuit is hardly affected by influences such as a sub resonance of a piezoelectric element or abnormal oscillations caused by stray capacitances and wiring in the circuit.

Fig. 22 shows drive level vs. negative resistance characteristic. As is clear from Fig. 22, the drive level at a steady state can be reduced from 3.2 mA to 1.8 mA, even though the negative resistance at oscillation start time (at a small signal) is the same, by including the resonance circuit in the high frequency Colpitts oscillation circuit.

The above description is an example of applying the invention to a Colpitts oscillation circuit structured by using a fundamental wave. However, the invention is not limited to this, and can be applied to a Colpitts oscillator structured by using a third-order harmonic quartz crystal resonator or a fifth-order harmonic quartz crystal resonator. Further, the embodiments are examples of using a source grounded amplifier circuit and an emitter follower as the voltage controlled voltage source, but the present invention is not limited to this.

The Colpitts oscillation circuit of the invention is structured so that the output of a voltage source circuit is fed back to a collector side of a Colpitts oscillation circuit through a coupling capacitor in a voltage controlled piezoelectric oscillator, and has an advantage in that a large negative resistance is obtained even in a GHz band by a phase shift due to the coupling capacitance and the capacitance between a base and a collector.

The prototype VCSO having a frequency of 1GHz that is made by using the high frequency Colpitts oscillation circuit shows favorable characteristics. In addition, the high frequency Colpitts oscillation circuit including the resonance circuit allows the peak of the negative resistance to be set around the oscillation frequency, resulting in the negative resistance being further increased. As a result, the circuit can be used in a higher frequency band as compared with a conventional high frequency Colpitts oscillation circuit, and can be oscillated at a low drive level.

**Claims**

1.    A high frequency Colpitts oscillation circuit, comprising:

    a Colpitts oscillation circuit; and
    a collector grounded amplifier circuit, wherein an output terminal of the Colpitts oscillation circuit is coupled to an input terminal of the collector grounded amplifier circuit, and an output terminal of the collector grounded amplifier circuit is coupled to the Colpitts oscillation circuit as feedback.

2.    A high frequency Colpitts oscillation circuit, comprising:

    a Colpitts oscillation circuit including a first transistor as an oscillation amplifier; and
    a collector grounded amplifier circuit including a second transistor as an amplifier, wherein an emitter of the first transistor is coupled to a base of the second transistor, and a collector of the first transistor is coupled to an emitter of the second transistor.

3.    The high frequency Colpitts oscillation circuit according to claim 2, further comprising a parallel resonance circuit composed of a capacitor and an inductor, the parallel resonance circuit being inserted and coupled between the emitter of the first transistor and ground potential.

**FIG. 1**

NEGATIVE RESISTANCE CHARACTERISTIC CURVE

**FIG. 2**

NEGATIVE RESISTANCE CHARACTERISTIC
CURVE WHEN AN IDEAL TRANSISTOR IS USED

COLPITTS OSCILLATION CIRCUIT
(AN IDEAL TRANSISTOR IS USED)

EXPANDED COLPITTS OSCILLATION
CIRCUIT OF THE INVENTION

## FIG. 3

NEGATIVE RESISTANCE CHARACTERISTIC CURVE
WHEN THE CAPACITANCE BETWEEN COLLECTOR
AND EMITTER IS TAKEN INTO CONSIDERATION

※ NOT DEPENDED ON THE
CHANGE OF Cbe

0.7 [pF]

0.5 [pF]

0.1 [pF]

## FIG. 4

NEGATIVE RESISTANCE CHARACTERISTIC CURVE
WHEN THE CAPACITANCE BETWEEN BASE
AND COLLECTOR IS TAKEN INTO CONSIDERATION

## FIG. 5

## FIG. 6

FIG. 7

FIG. 8

## FIG. 9

## FIG.10

FIG.11

FIG.12

**FIG.13**

**FIG.14**

FIG.15

FIG.16

FIG.17

1GHz VCSO No.1 vs. No.2

FIG.18

16

**FIG.19**

**FIG.20**

HIGH FREQUENCY COPITTS USING RESONATOR

HIGH FREQUENCY COPITTS

FIG.21

HIGH FREQUENCY COLPITTS USING RESONATOR

HIGH FREQUENCY COLPITTS

FIG.22

FIG.23

NEGATIVE RESISTANCE CHARACTERISTIC CURVE

FIG.24

**European Patent Office**

# EUROPEAN SEARCH REPORT

Application Number

EP 06 02 1879

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 479 096 A (FOWKS WILLIAM R [US]) 23 October 1984 (1984-10-23) * column 5, line 31 - line 38; figure 2 * | 1-3 | INV. H03B5/12 H03B5/36 |
| X | US 6 606 007 B1 (WASHBURN CLYDE [US]) 12 August 2003 (2003-08-12) * column 6, line 60 - column 7, line 20; figure 9 * | 1-3 | |
| X | US 5 900 788 A (HAGEMEYER FRANK [DE]) 4 May 1999 (1999-05-04) * column 3, line 28 - column 4, line 21; figure 2 * | 1-3 | |
| A | EP 1 505 720 A (SYNERGY MICROWAVE CORP [US]) 9 February 2005 (2005-02-09) * abstract; figure 3 * | 1-3 | |

TECHNICAL FIELDS
SEARCHED        (IPC)

H03B

The present search report has been drawn up for all claims

| Place of search | Date of completion of the search | Examiner |
|---|---|---|
| The Hague | 1 March 2007 | BEASLEY-SUFFOLK, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 02 1879

This annex lists the patent family members relating to the patent documents cited in the above-mentioned European search report.
The members are as contained in the European Patent Office EDP file on
The European Patent Office is in no way liable for these particulars which are merely given for the purpose of information.

01-03-2007

| Patent document cited in search report | | Publication date | Patent family member(s) | | Publication date |
|---|---|---|---|---|---|
| US 4479096 | A | 23-10-1984 | NONE | | |
| US 6606007 | B1 | 12-08-2003 | NONE | | |
| US 5900788 | A | 04-05-1999 | DE | 19652146 A1 | 25-06-1998 |
| EP 1505720 | A | 09-02-2005 | CA | 2534370 A1 | 17-02-2005 |
| | | | JP | 2007501574 T | 25-01-2007 |
| | | | WO | 2005015731 A2 | 17-02-2005 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **MIYAKE.** Transistor Crystal Oscillator. *Journal of the Institute of Electronics, Information and Communication Engineers,* 1970, vol. 53 (6), 771-777
- **KAWASHIMA ; HIRAMA ; SAITOU ; KOYAMA.** Quartz Resonators and Devices. *Institute of Electronics, Information and Communication Engineers Transactions, C,* December 1999, vol. J82-C (12), 667-682
- **SAKUTA ; MINO ; SEKINE.** A Study on Phase Noise Measurement of High Accuracy Oscillator using Magnification of Phase Noise. *Institute of Electronics, Information and Communication Engineers Transactions, C,* September 1999, vol. J82-C (9), 486-492
- **SHIMONO.** Crystal Oscillator Suppressing CI Dip Frequency Jump. *Institute of Electronics, Information and Communication Engineers Transactions, C,* April 2002, vol. J85-C (4), 249-259